# EUROPEAN PATENT SPECIFICATION

(11) **EP 0 474 348 B1**
(45) Date of publication and mention of the grant of the patent: **20.09.1995**
(21) Application number: 91306547.0
(22) Date of filing: 18.07.1991
(51) Int. Cl.: C23C 14/34, C23C 14/14, H01J 37/34

(54) **Sputtering apparatus and method for producing thin films of material**
Sputteranlage und -verfahren zur Erzeugung dünner Werkstoffschichten
Appareillage et procédé de pulvérisation cathodique pour la production de couches minces de matériaux

(30) Priority: 31.08.1990 US 576254
(43) Date of publication of application: 11.03.1992
(73) Proprietor: International Business Machines Corporation, Armonk, N.Y. 10504 (US)
(72) Inventor: Galicki, Arkadi, Cupertino, California 95014 (US); Horng, Cheng Tzong, San Jose, California 95120 (US); Schwenker, Robert Otto, San Jose, California 95120 (US)
(74) Representative: Burt, Roger James, Dr.

(56) References cited:
- WO-A-89/05362
- GB-A- 2 110 720
- GB-A- 2 111 085
- US-A- 4 511 593
- PATENT ABSTRACTS OF JAPAN vol. 9, no. 56 (E-302)(1779) 12 March 1985 ; & JP-A-59 195 888
- SOLID STATE TECHNOLOGY vol. 16, no. 12, December 1973, WASHINGTON, US, pp. 100-103 ; E.D. SEGAL : "NEW GEOMETRY IN SPUTTERING TECHNOLOGY"

## Description

Sputtering apparatus has been extensively used in the production of thin films of material. In depositing these films, a variety of properties are of concern, and many factors, which may involve the particular apparatus being used, determine these properties of interest. In addition, in order to increase the processing rate in manufacturing, the substrates upon which the thin films of material are deposited, are moved in a continuous fashion during the deposition process. This is an added variable which affects the film properties, and may cause the uniformity of the film properties to be poor and/or difficult to control.

Among the thin film properties considered to be important are the thickness of the thin film of material and the thickness uniformity of the thin film of material over the area of the substrate. U.S. patent 3,904,503 describes a sputtering apparatus in which a solid shield member is inserted between the target and substrate during some part of the sputtering time and then withdrawn. When the shield member is in place, a portion of the substrate is shaded to prevent excess deposition of material, thereby producing improved uniformity of thickness of the material.

U.S. patent 4,315,960 shows a sputtering apparatus in which two solid mask plates are located between the target and the substrate. The mask plates are reciprocated relative to each other and to the substrate during deposition of material so that the thin films are produced with uniform thickness.

Japanese published unexamined patent application 60-197869 shows a sputtering apparatus in which a mask plate is positioned between the target and the substrate. The mask plate has an opening through which the sputtered material passes, and the opening is widest at the ends of the opening and narrowest at the middle of the opening so that the thickness of the thin films deposited on the substrates is almost uniform.

US-A-4511593 discloses sputtering apparatus in which a shutter is used to block atoms travelling in a line of sight path between a source and a substrate.

WO89/05362 discloses sputtering apparatus for manufacturing a magnetic disk in which a shield arrangement in the form of an annular mask having a central opening is used to block atoms travelling at or near normal incidence to a substrate so that a chromium layer is deposited at a high angle of incidence to set up seed characteristics for a later deposited magnetic layer.

According to the present invention there is provided a sputtering apparatus comprising: a first electrode assembly having means for supporting at least one target member thereon; a second electrode assembly having means for supporting at least one substrate thereon; means for producing relative motion between said first and second electrode assemblies; a source of power arranged to impose a voltage across said first and second electrode assemblies to produce a glow discharge in the space between said first and second electrode assemblies and thereby sputter atoms from the target member or members onto the substrate or substrates; and shutter means positioned between said first and second electrode assemblies, said shutter means having a masking portion or portions for blocking a substantial proportion of the sputtered atoms travelling at or near normal incidence to the substrate or substrates, the shutter means having at least one opening shaped to pass a substantial proportion of the sputtered atoms travelling at an oblique angle to impinge on the substrate or substrates, the arrangement of the shutter and the relative motion of the first and second electrodes being such that a thin film of substantially uniform thickness of the atoms sputtered from the target can be formed across the substrate, characterised in that said shutter means comprises an elongate masking member extending radially across the or each opening, said elongate masking member having a central region which separates two end regions, said central region being wider than said end regions and being operative to block a substantial proportion of the sputtered atoms travelling at or near normal incidence to the substrate.

Further according to the present invention there is provided a method of sputtering in which a target member is supported on a first electrode assembly, a substrate is supported on a second electrode assembly, the first and second electrode assemblies are moved relative to one another and a voltage is imposed across the first and second electrode assemblies to produce a glow discharge in the space between the first and second electrode assemblies to sputter atoms from the target member onto the substrate, a shutter means is positioned between the first and second electrode assemblies the shutter means incorporating a masking portion which blocks a substantial proportion of the sputtered atoms travelling at or near normal incidence to the substrate, the shutter means having an opening shaped to pass a substantial proportion of the sputtered atoms travelling at an oblique angle to impinge on the substrate, the arrangement of the shutter and the relative motion of the first aid second electrodes being such that a thin film of substantially uniform thickness of the atoms sputtered from the target is formed across the substrate characterised in that said shutter means comprises an elongate masking member extending radially across the or each opening, said elongate masking member having a central region which separates the end regions, said central region being wider than said end regions and operating to block a substantial proportion of the sputtered atoms travelling at or near normal incidence to the substrate.

This sputtering apparatus and method are particularly useful for depositing an oriented magnetic film without the use of an external applied magnetic field to align the magnetic material. By depositing at an oblique angle of incidence, magnetic films with anisotropic properties can be produced in a chosen direction.

In the drawings:
Fig. 1 is a schematic view showing the general arrangement of the elements and power supply of sputtering apparatus according to the present invention,
Fig. 2. is a schematic plan view of a specific embodiment of the substrate electrode assembly with substrate loaded in the apparatus of Figure 1,
Fig. 3 is a schematic plan view of a specific embodiment of the target electrode assembly in the apparatus of Figure 1,
Fig. 4 is a plan view of a specific embodiment of the shutter means in the apparatus of Figure 1 and,
Fig. 5 is an enlarged view showing the detailed shape of the openings in the shutter means of Fig. 4.

### Description of the Preferred Embodiment

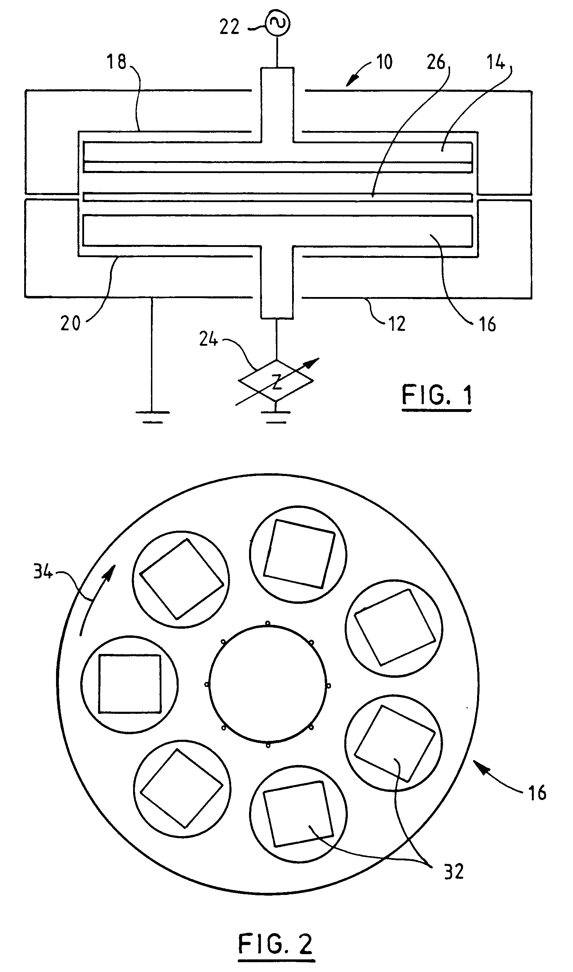

Referring to Fig. 1, the general structure of the electrode assemblies and the power supply is shown for the sputtering apparatus according to the present invention. The sputtering apparatus 10 of the invention comprises a vacuum enclosure 12 and vacuum pumps (not shown) to evacuate the sputtering enclosure to a desired background pressure level. A suitable sputtering gas such as argon, for example, is then fed into the enclosure to provide the necessary background environment for sputter deposition.

A target electrode assembly 14 to which a circular disk-shaped target body is mounted is positioned within the enclosure 12, and a substrate electrode assembly 16 is positioned adjacent to and facing the target electrode assembly 14. The electrode assemblies 14 and 16 may be water cooled to maintain a desired temperature during operation. To eliminate spurious sputtering that may occur at the back of the electrode assemblies 14 and 16, each electrode assembly 14 and 16 has a ground shield 18 and 20, respectively, surrounding the peripheral and back portions of the electrode assembly, thereby leaving the face of the electrode assemblies exposed for supporting target bodies and substrates to be coated.

The power supply 22 is connected to supply an RF voltage potential across target electrode assembly 14, substrate electrode assembly 16, and variable impedance 24 to produce a glow discharge in the space between the target electrode assembly 14 and the substrate electrode assembly 16.

The capacitive and inductive components of variable impedance 24 can be varied to control the voltage to substrate electrode assembly 16 to provide control over the properties of the films deposited by the sputtering apparatus. Alternatively, sputtering of the target material can be done by using the DC sputtering mode.

According to the present invention, a shutter means having an opening, which will be described in detail below, is positioned between the target electrode assembly and the substrate electrode assembly. This structure enables the sputtering apparatus to produce thin films of material with uniform thickness across a substrate and from substrate to substrate by blocking a substantial part of the sputtered atoms from the target(s) traveling at or near normal incidence to the substrates and permitting a substantial part of the sputtered atoms traveling at an oblique angle to impinge upon the substrate to produce the thin film of material.

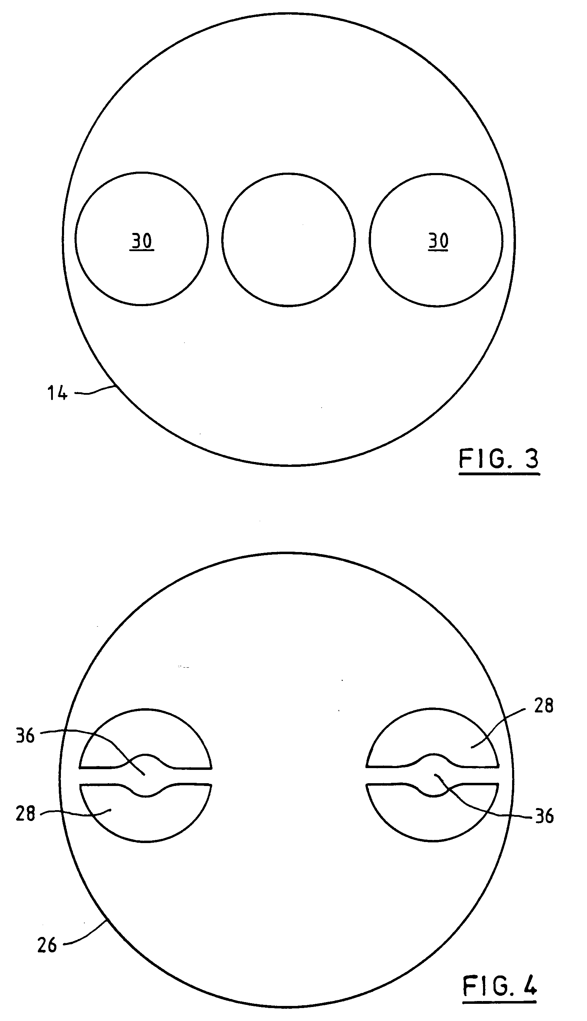

As shown in Fig. 1, a shutter means 26 is fixed in position in the space between target electrode assembly 14 and substrate electrode assembly 16. Shutter means 26, as shown in Fig. 4, has at least one opening 28 through which sputtered atoms from the target member 30, mounted on target electrode assembly 14, can impinge on a substrate 32 which is mounted on substrate electrode assembly 16.

In the embodiment shown in the drawings (Fig. 3), target electrode assembly 14 comprises two target members 30 mounted along opposite ends of a radial line. Target members 30 comprise a suitable material chosen for the thin films which are to be deposited on the substrates. The material may comprise metals and/or alloys and may comprise ferromagnetic metals and/or alloys. In the embodiment of the substrate electrode assembly 16 shown in the drawings (Fig. 2) a plurality of substrates 32 are mounted around a central opening. Relative motion is provided between target electrode assembly 14 and substrate electrode assembly 16 in the direction of the arrow 34.

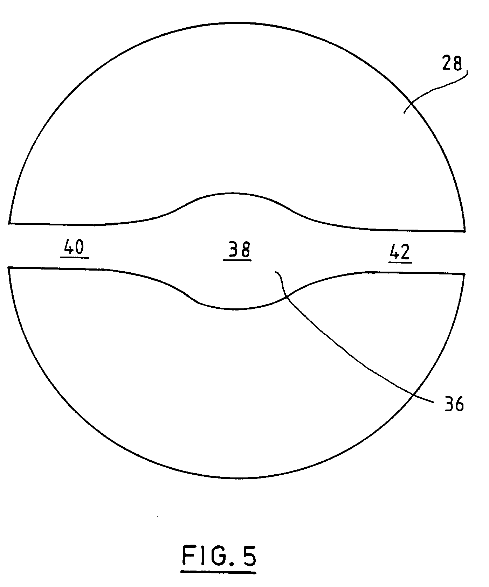

In the embodiment of the shutter means 26 shown in the drawing (Fig. 4), two openings 28 are provided with an opening 28 in alignment with each of the target members 30. Opening 28 comprise an opening of substantially the same shape as the target member 30 with the exception of a masking member 36 which extends radially across the centre of opening 28. Masking member 36 (Fig. 5) comprises a wider central area 38 supported by narrower spoke portions in which the central spoke portion 40 (i.e. the portion nearest the centre of shutter means 26) is wider than the outside spoke portion 42.

During the glow discharge sputtering, the target atoms are ejected from the target surface at various angles, so a distribution of sputtered atoms is produced with the peak distribution in a direction normal to the target member 30. Since opening 28 is aligned with target member 30, the central area 38 of masking member 36 is in a position to block a substantial part of the sputtered atoms traveling at or near normal incidence to the substrate 32. However, a substantial part of the sputtered atoms traveling at an oblique angle goes through the opening 28 on either side of masking member 36 and impinges on a substrate 32 to produce a thin film of the target member 30 material on the substrate 32.

The sputtering apparatus according to the present invention functions to provide a thin film of a variety of materials having a uniform thickness both on a substrate as well as from substrate to substrate.

When depositing ferromagnetic metals and/or alloys in the prior art, it is generally required that the thin film of ferromagnetic material be deposited in the presence of an external applied magnetic field should it be desired to have a thin film of magnetic material with magnetisation oriented in a chosen direction.

It has been discovered that thin films of magnetic materials, such as NiFe and Sendust, for example, can be deposited by the sputtering apparatus according to the present invention and achieve a thin film of magnetic material oriented in a particular direction without the use of an external applied magnetic field to orient the magnetic material. In this case the easy axis of the thin film of magnetic material is in the radial direction as the substrates 32 are shown in Fig. 2.

## Claims

1. Sputtering apparatus comprising:
a first electrode assembly (14) having means for supporting at least one target member (30) thereon;
a second electrode assembly (16) having means for supporting at least one substrate (32) thereon;
means for producing relative motion between said first and second electrode assemblies;
a source of power (22) arranged to impose a voltage across said first and second electrode assemblies to produce a glow discharge in the space between said first and second electrode assemblies and thereby sputter atoms from the target member or members onto the substrate or substrates; and
shutter means (26) positioned between said first and second electrode assemblies, said shutter means (26) having a masking portion or portions (36) for blocking a substantial proportion of the sputtered atoms travelling at or near normal incidence to the substrate or substrates (32), the shutter means (26) having at least one opening (28) shaped to pass a substantial proportion of the sputtered atoms travelling at an oblique angle to impinge on the substrate or substrates (32), the arrangement of the shutter and the relative motion of the first and second electrodes being such that a thin film of substantially uniform thickness of the atoms sputtered from the target can be formed across the substrate, characterised in that said shutter means (26) comprises an elongate masking member (36) extending radially across the or each opening (28), said elongate masking member having a central region which separates two end regions, said central region being wider than said end regions and being operative to block a substantial proportion of the sputtered atoms travelling at or near normal incidence to the substrate.

2. The sputtering apparatus according to Claim 1 wherein the target member or members (30) comprise a metal or an alloy.

3. The sputtering apparatus according to Claim 2 wherein said metal or alloy is ferromagnetic.

4. The sputtering apparatus according to Claim 3 wherein the ferromagnetic material is taken from the group consisting of NiFe and Sendust.

5. The sputtering apparatus of Claim 1, 2, 3 or 4, wherein said first electrode supports a plurality of target members (30) and said shutter means (26) has a plurality of openings (28) with an opening (28) in alignment with each of said target members.

6. A method of sputtering in which a target member (30) is supported on a first electrode assembly (14),
a substrate (32) is supported on a second electrode assembly (16),
the first and second electrode assemblies are moved relative to one another and a voltage is imposed across the first and second electrode assemblies (14, 16) to produce a glow discharge in the space between the first and second electrode assemblies (14, 16) to sputter atoms from the target member (30) onto the substrate (32),
a shutter means (26) is positioned between the first and second electrode assemblies (14, 16) the shutter means (26) incorporating a masking portion (26) which blocks a substantial proportion of the sputtered atoms travelling at or near normal incidence to the substrate (32), the shutter means (26) having an opening (28) shaped to pass a substantial proportion of the sputtered atoms travelling at an oblique angle to impinge on the substrate (32),
the arrangement of the shutter and the relative motion of the first and second electrodes being such that a thin film of substantially uniform thickness of the atoms sputtered from the target is formed across the substrate characterised in that said shutter means (26) comprises an elongate masking member (36) extending radially across the or each opening (28), said elongate masking member having a central region which separates the end regions, said central region being wider than said end regions and operating to block a substantial proportion of the sputtered atoms travelling at or near normal incidence to the substrate.

## Patentansprüche

1. Sputteranlage, bestehend aus:
einer ersten Elektrodenanordnung (14), das ein Mittel zur Halterung mindestens eines Zielglieds (30) umfaßt;
einer zweiten Elektrodenanordnung (16), das ein Mittel zur Halterung mindestens eines Substrats (32) umfaßt;
einem Mittel zur Erzeugung einer relativen Bewegung zwischen der genannten ersten und der genannten zweiten Elektrodenanordnung;
einer Stromquelle (22), die so eingerichtet ist, daß sie zwischen der genannten ersten und der genannten zweiten Elektrodenanordnung eine Spannung anlegt, die eine Funkenentladung im Zwischenraum zwischen der genannten ersten und der genannten zweiten Elektrodenanordnung erzeugt, wodurch Atome vom Zielglied oder von den Zielgliedern auf das Substrat oder die Substrate aufgesputtert werden; und
einem Schließmittel (26), das sich zwischen der genannten ersten und der genannten zweiten Elektrodenanordnung befindet, wobei das genannte Schließmittel (26) einen Maskierteil oder mehrere Maskierteile (36) zur Blockierung eines wesentlichen Anteils der gesputterten Atome besitzt, die normal oder nahezu normal zum Substrat oder zu den Substraten (32) wandern, wobei das Schließmittel (26) mindestens eine Öffnung (28) besitzt, deren Form derart gestaltet ist, daß ein wesentlicher Anteil der gesputterten Atome, die schiefwinklig auf dem Substrat oder auf den Substraten (32) auftreffen, passieren kann, wobei die Anordnung des Schließmittels und die relative Bewegung der ersten und der zweiten Elektrode derart gestaltet ist, daß eine dünne Schicht mit einer im wesentlichen gleichen Dicke der vom Zielglied gesputterten Atome auf dem Substrat gebildet werden kann, dadurch charakterisiert, daß das genannte Schließmittel (26) ein verlängertes Maskierglied (36) umfaßt, das sich radial über die oder jede Öffnung (28) erstreckt, wobei das genannte verlängerte Maskierglied einen mittleren Bereich besitzt, der zwei Endbereiche voneinander trennt, wobei der genannte mittlere Bereich breiter ist als die genannten Endbereiche und einen wesentlichen Anteil der gesputterten Atome, die normal oder nahezu normal zum Substrat wandern, blockiert.

2. Sputteranlage gemäß Anspruch 1, bei der das Zielglied oder die Zielglieder (30) ein Metall oder eine Legierung umfassen.

3. Sputteranlage gemäß Anspruch 2, bei der das genannte Metall oder die genannte Legierung ferromagnetisch ist.

4. Sputteranlage gemäß Anspruch 3, bei der das ferromagnetische Material aus der Gruppe stammt, die sich aus NiFe und Sendust zusammensetzt.

5. Sputteranlage gemäß den Ansprüchen 1, 2, 3 oder 4, bei der die genannte erste Elektrode eine Mehrzahl an Zielgliedern (30) trägt und das genannte Schließmittel (26) eine Mehrzahl an Öffnungen (28) enthält, von denen jede Öffnung (28) auf eine der genannten Zielglieder ausgerichtet ist.

6. Sputterverfahren, bei dem ein Zielglied (30) auf einer ersten Elektrodenanordnung (14) angebracht ist,
ein Substrat (32) wird von einer zweiten Elektrodenanordnung (16) getragen,
die erste und die zweite Elektrodenanordnung werden relativ zueinander bewegt und eine Spannung an die erste und an die zweite Elektrodenanordnung (14, 16) angelegt, um eine Funkenentladung im Zwischenraum zwischen der ersten und der zweiten Elektrodenanordnung (14, 16) zu erzeugen, wodurch Atome vom Zielglied (30) auf das Substrat (32) aufgesputtert werden,
ein Schließmittel (26) wird zwischen der ersten und der zweiten Elektrodenanordnung (14, 16) positioniert, wobei das Schließmittel (26) einen Maskierteil (26) enthält, der einen wesentlichen Anteil der gesputterten Atome blockiert, die normal oder nahezu normal zum Substrat (32) wandern, und wobei das Schließmittel (26) eine Öffnung (28) besitzt, deren Form derart gestaltet ist, daß ein wesentlicher Anteil der gesputterten Atome, die schiefwinklig auf dem Substrat (32) auftreffen, passieren kann,
und wobei die Anordnung des Schließers und und die relative Bewegung der ersten und der zweiten Elektrode derart gestaltet ist, daß eine dünne Schicht mit einer im wesentlichen gleichen Dicke der vom Zielglied gesputterten Atome auf dem Substrat gebildet werden kann, dadurch charakterisiert, daß das genannte Schließmittel (26) ein verlängertes Maskierglied (36) umfaßt, das sich radial über die oder jede Öffnung (28) erstreckt, wobei das genannte verlängerte Maskierglied einen mittleren Bereich besitzt, der die Endbereiche voneinander trennt, wobei der genannte mittlere Bereich breiter ist als die genannten Endbereiche und einen wesentlichen Anteil der gesputterten Atome, die normal oder nahezu normal zum Substrat wandern, blockiert.

## Revendications

1. Appareil de pulvérisation comprenant:
une première structure d'électrode (14) ayant des moyens pour porter au moins un membre cible (30);
une deuxième structure d'électrode (16) ayant des moyens pour porter au moins un substrat (32);
des moyens pour produire un déplacement relatif entre lesdites première et deuxième structures d'électrode;
une source d'énergie (22) agencée pour appliquer une tension sur lesdites première et deuxième structures d'électrode afin de produire une décharge dans l'espace situé entre lesdites première et deuxième structure d'électrode et pulvériser de ce fait des atomes depuis l'élément, ou les éléments, cible sur le substrat, ou les substrats; et
un moyen obturateur (26) placé entre lesdites première et deuxième structures d'électrode, ledit moyen obturateur (26) ayant une portion ou des portions de masquage (36) pour bloquer une proportion importante des atomes pulvérisés se déplaçant sous incidence normale, ou presque, par rapport au substrat ou substrats (32), le moyen obturateur (26) ayant au moins une ouverture (28) dont la forme laisse passer une proportion importante des atomes pulvérisés se déplaçant sous incidence oblique pour venir frapper contre le substrat ou les substrats (32), l'agencement de l'obturateur et le déplacement relatif des première et deuxième électrodes étant tels qu'un mince film d'épaisseur sensiblement uniforme des atomes pulvérisés depuis la cible peut être formé sur le substrat,
caractérisé en ce que ledit moyen obturateur (26) comprend un membre de masquage allongé (36) traversant radialement le centre de l'ouverture (28), ledit membre de masquage allongé ayant une région centrale qui sépare deux régions extrêmes, ladite région centrale étant plus large que lesdites régions extrêmes et fonctionnant pour bloquer une proportion importante des atomes pulvérisés se déplaçant sous incidence normale, ou presque, par rapport au substrat.

2. Appareil de pulvérisation selon la revendication 1, dans lequel le membre ou les membres cible (30) sont un métal ou un alliage.

3. Appareil de pulvérisation selon la revendication 2, dans lequel ledit métal ou alliage est ferromagnétique.

4. Appareil de pulvérisation selon la revendication 3, dans lequel le matériau ferromagnétique est pris dans le groupe comprenant NiFe et Sendust.

5. Appareil de pulvérisation selon les revendications 1, 2, 3 ou 4, dans lequel ladite première électrode porte une pluralité de membres cible (30) et ledit moyen obturateur (26) a une pluralité d'ouvertures (28) avec une ouverture (28) en alignement avec chacun desdits membres cible.

6. Procédé de pulvérisation, dans lequel un membre cible (30) est porté par une première structure d'électrode (14),
un substrat (32) est porté par une deuxième structure d'électrode (16),
les première et deuxième structures d'électrode se déplacent entre elles et une tension est appliquée sur les première et deuxième structures d'électrode (14, 16) afin de produire une décharge dans l'espace situé entre les première et deuxième structures d'électrode (14, 16) et de pulvériser des atomes depuis le membre cible (30) sur le substrat (32),
un moyen obturateur (26) est placé entre les première et deuxième structures d'électrode (14, 16), le moyen obturateur (26) incorporant une portion de masquage (26) qui bloque une proportion importante des atomes pulvérisés se déplacant sous incidence normale, ou presque, par rapport au substrat (32), le moyen obturateur (26) ayant une ouverture (28) dont la forme laisse passer une proportion importante des atomes pulvérisés se déplaçant sous incidence oblique pour venir frapper contre le substrat (32),
L'agencement de l'obturateur et le déplacement relatif des première et deuxième électrodes étant tels qu'un mince film d'épaisseur sensiblement uniforme des atomes pulvérisés depuis la cible est formé sur le substrat,
caractérisé en ce que ledit moyen obturateur (26) comprend un membre de masquage allongé (36) traversant radialement le centre de l'ouverture (28), ledit membre de masquage allongé ayant une région centrale qui sépare les régions extrêmes, ladite région centrale étant plus large que lesdites régions extrêmes et fonctionnant pour bloquer une proportion importante des atomes pulvérisés se déplaçant sous incidence normale, ou presque, par rapport au substrat.
